# EUROPÄISCHE PATENTSCHRIFT

(11) **EP 1 095 399 B1**
(45) Veröffentlichungstag und Bekanntmachung des Hinweises auf die Patenterteilung: **20.02.2002**
(21) Anmeldenummer: 99944590.1
(22) Anmeldetag: 02.09.1999
(51) Int. Cl.: H01L 21/00

(54) **VERFAHREN ZUR HANDHABUNG EINER MEHRZAHL VON SCHALTUNGSCHIPS**
METHOD FOR HANDLING A PLURALITY OF CIRCUIT CHIPS
PROCEDE POUR MANIPULER UNE PLURALITE DE PUCES DE CONNEXION

(30) Priorität: 03.09.1998 DE 19840210
(43) Veröffentlichungstag der Anmeldung: 02.05.2001
(73) Patentinhaber: Fraunhofer-Gesellschaft zur Förderung der angewandten Forschung e.V., 80636 München (DE)
(72) Erfinder: PLETTNER, Andreas, D-82340 Feldafing (DE); HABERGER, Karl, D-82152 Planegg (DE); LANDESBERGER, Christof, D-81241 München (DE)
(74) Vertreter: Schoppe, Fritz, Dipl.-Ing.
(86) Internationale Anmeldenummer: EP9906468
(87) Internationale Veröffentlichungsnummer: WO0014773

(56) Entgegenhaltungen:
- EP-A- 0 431 637
- JP-A- 10 107 490
- PATENT ABSTRACTS OF JAPAN vol. 1998, no. 06, 30. April 1998 (1998-04-30) -& JP 10 041695 A (MATSUSHITA ELECTRIC IND CO LTD), 13. Februar 1998 (1998-02-13)

## Beschreibung

Die vorliegende Erfindung bezieht sich auf die parallele Handhabung einer Mehrzahl von Schaltungschips, und insbesondere eine gleichzeitige parallele Handhabung einer Mehrzahl von Schaltungschips mittels einer Mehrzahl von Aufnahmeeinrichtungen.

Durch die Entwicklung von kontaktbehafteten und kontaklosen Chipkarten sowie kontaktlosen elektronischen Etiketten hat sich ein völlig neuer und schnell wachsender Markt für elektronische Mikro-Systeme mit neuen Anforderungen ergeben. Integrierte Schaltungen werden nicht mehr lediglich in Großgeräte oder auch Handsysteme eingebaut, sondern sozusagen "nackt" in Chipkarten oder elektronische Etiketten. Die elektronischen Etiketten stellen derzeit als sogenannte "Wegwerfelektronik" das Ende dieser Entwicklung dar. Eine derartige Wegwerfelektronik erfordert preisgünstige Chips bzw. integrierte Schaltungen. Um derartige preisgünstige Chips realisieren zu können, sind insbesondere Verfahren für eine preisgünstige Massenfertigung notwendig.

Eine preisgünstige Massenfertigung ist nur realisierbar, wenn möglichst lange eine parallele Fertigung einer Vielzahl von Schaltungschips im Wafer-Verbund durchgeführt wird. Somit wird üblicherweise die in einem Schaltungschip enthaltene integrierte Schaltung fertiggestellt, während der Schaltungschip noch im Waferverbund mit anderen Schaltungschips angeordnet ist. Erst nach Fertigstellung der integrierten Schaltungen werden die Wafer in die einzelnen Schaltungschips vereinzelt.

Nach der Vereinzelung der Halbleiterwafer in den einzelnen Schaltungschips müssen diese gehandhabt werden, um dieselben an ihrem endgültigen Bestimmungsort, d.h. auf dem Schaltungssubstrat, zu positionieren. Nach dem Vereinzeln der Schaltungschips sind diese üblicherweise noch im Pseudo-Waferverbund auf einem Hilfssubstrat angeordnet. Pseudo-Waferverbund heißt, daß die Schaltungschips noch in der Anordnung und Beabstandung des ursprünglichen Waferverbunds positioniert sind, jedoch durch Trennfugen voneinander getrennt sind. Üblicherweise wird nun zur Weiterverarbeitung jeweils ein einzelner Schaltungschip mittels einer Greifvorrichtung von dem Hilfssubstrat entnommen und mittels der Greifvorrichtung für die weitere Bearbeitung gehandhabt.

Aus JP 10041695 A und den zugehörigen Patent Abstracts of Japan, Vol. 1998, Nr. 06, 30. April 1998, ist eine Chiphandhabungsvorrichtung bekannt, die einen Aufnahmekopf aufweist, der eine Mehrzahl von Aufnahmedüsen mit einer festen räumlichen Beziehung zueinander besitzt. Der Aufnahmekopf ist frei bewegbar, um die Chips zu einer Befestigungsposition zu bewegen und dort zu befestigen.

Die JP 10107490 A zeigt eine Vorrichtung zur gleichzeitigen Aufnahme mehrerer Schaltungschips, die einen Aufnahmekopf mit einer Mehrzahl von Aufnahmedüsen aufweist. Gemäß dieser Druckschrift wird eine Positionsbeziehung zwischen den Düsen durch eine erste Kamera aufgenommen, während eine Positionsbeziehung aufzunehmender Chips durch eine zweite Kamera beobachtet wird. Ergeben diese Beobachtungen, daß alle Aufnahmedüsen innerhalb eines Toleranzbereichs der Chips, der eine ordnungsgemäße Aufnahme derselben gewährleistet, angeordnet sind, werden die Chips durch eine gleichzeitige Auf- und Ab-Bewegung der einzelnen Aufnahmedüsen aufgenommen. Ergibt diese Beobachtung jedoch, daß sich eine der Düsen nicht innerhalb des Toleranzbereichs eines jeweiligen Chips befindet, werden zunächst nur diejenigen Chips gleichzeitig aufgenommen, deren Aufnahmedüse sich in dem Toleranzbereich befindet. Die Düse, die sich nicht in dem Toleranzbereich befindet, wird nachfolgend durch eine Horizontalbewegung räumlich eingestellt, um in den Toleranzbereich des aufzunehmenden Chips zu gelangen. Dieser Chip wird nach dieser Einstellung der Düse einzeln aufgenommen.

Die Aufgabe der vorliegenden Erfindung gemäß dem Anspruch 1 besteht darin, ein Verfahren zu liefern, das auch nach der Vereinzelung von Schaltungschips aus dem Waferverbund eine parallele Weiterbehandlung ermöglicht.

Diese Aufgabe wird durch ein Verfahren gemäß Patentanspruch 1 gelöst.

Die vorliegende Erfindung schafft ein Verfahren zur parallelen Handhabung einer Mehrzahl von Schaltungschips, die in einer ersten Anordnung, die der Anordnung derselben im ursprünglichen Waferverbund entspricht, auf der Oberfläche eines Hilfsträgers angeordnet sind. Zunächst wird eine Mehrzahl von Schaltungschips gleichzeitig durch eine Mehrzahl von Aufnahmeeinrichtungen aufgenommen. Nachfolgend die Mehrzahl von Aufnahmeeinrichtungen mit den aufgenommenen Schaltungschips gleichzeitig zu einem oder mehreren Träger bewegt, derart, daß gleichzeitig mit der Bewegung die erste Anordnung der Schaltungschips in eine zweite, von der ersten Anordnung verschiedene Anordnung geändert wird. Die Schaltungschips werden dann gleichzeitig auf dem oder den Trägern plaziert.

Vorzugsweise definiert die erste Anordnung der Schaltungschips erste Beabstandungen zwischen denselben, während die zweite Anordnung zweite Beabstandungen zwischen denselben festlegt, wobei die ersten Beabstandungen kleiner als die zweiten Beabstandungen sind. Als Aufnahmeeinrichtungen sind beliebige Einrichtunger denkbar, die jeweils geeignet sind, einen Schaltungschip zu halten, wobei beispielsweise eine magnetische Kupplung, eine elektrostatische Kupplung oder eine unterdruckkupplung verwendet werden kann. Ferner können Aufnahmeeinrichtungen verwendet werden, die mit einer Haftschicht versehen sind. Vorzugsweise werden die Schaltungschips jeweils von dem Hilfsträger gelöst, indem Energie zu der Verbindungsstelle zwischen Hilfsträger und Schaltungschip zugeführt wird.

Bei dem oder den Trägern, auf die die Schaltungschips aufgebracht werden, kann es sich um einen weiteren Hilfsträger handeln, bzw. um die Schaltungssubstrate, auf denen die Schaltungschips für ihre endgültige Bestimmung verbleiben sollen. Handelt es sich bei den Trägern um die Schaltungssubstrate, können die Schaltungschips gleichzeitig mit dem Plazieren derselben auf den Schaltungssubstraten beispielsweise durch Erwärmen der Aufnahmeeinrichtungen direkt auf diesen Schaltungssubstraten Flip-Chip-gebondet werden. Dabei sind auch andere Bondverfahren oder Klebeverfahren durchführbar.

Die vorliegende Erfindung beseitigt somit Nachteile des Stands der Technik, bei der die Schaltungschips nach der Vereinzelung derselben einer Einzelprozessierung unterworfen werden, wodurch die vorliegende Erfindung eine schnellere Fertigung ermöglicht. Indem gleichzeitig mehrere Schaltungschips aus dem Pseudo-Waferverbund gelöst werden, läßt sich die Prozeßdauer verringern. Beispielsweise können jeweils gleichzeitig Gruppen, beispielsweise 10 x 10 Schaltungschips, oder Reihen von Schaltungschips mittels des erfindungsgemäßen Verfahrens von einem Hilfsträger entfernt und mit einer größeren Beabstandung zwischen denselben auf ein Substrat aufgebracht werden.

Gemäß der vorliegenden Erfindung werden gleichzeitig mehrere Greifköpfe verwendet, die eine Querschnittfläche aufweisen, die kleiner oder gleich der Fläche der zu handhabenden Schaltungschips ist. Diese Mehrzahl von Greifköpfen wird elektronisch gesteuert, um dieselbe auf einer Gruppe von Schaltungschips zu plazieren, woraufhin die Schaltungschips von dem Hilfssubstrat abgelöst werden. Die einzelnen Greifköpfe sind über eine Handhabungsvorrichtung derart steuerbar, daß dieselben nach dem Aufnehmen der Schaltungschips fächerförmig auseinandergeführt werden können. Nachfolgend können die einzelnen Schaltungschips parallel, d.h. gleichzeitig, oder sequentiell auf den jeweiligen Trägern, d.h. dem Schaltungssubstrat für die endgültige Bestimmung, das die zur Kontaktierung des Schaltungschips erforderlichen elektrischen Kontakte aufweist, plaziert, d.h. gebondet oder geklebt, werden.

Bevorzugte Ausführungsbeispiele der vorliegenden Erfindung werden nachfolgend bezugnehmend auf die beiliegenden Zeichnungen näher erläutert. Es zeigen:

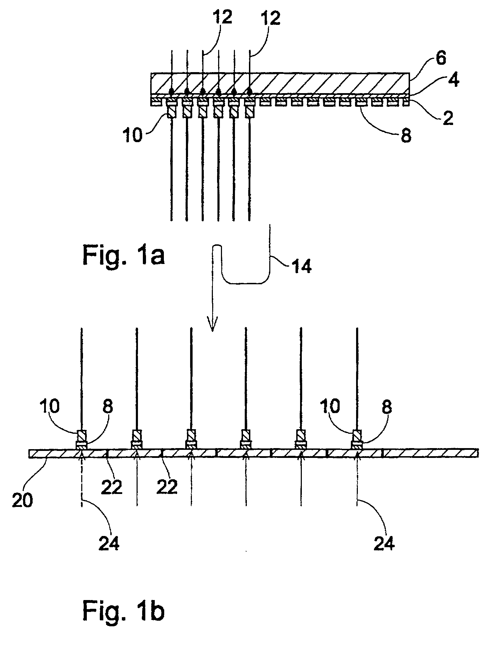

- Fig. 1a und 1b: schematische Darstellungen zur Veranschaulichung des erfindungsgemäßen Verfahrens.

In Fig. 1a ist eine Mehrzahl von Schaltungschips 2 gezeigt, die über eine Haftschicht 4 an einem Hilfssubstrat 6 angebracht sind. Die Schaltungschips 2 sind flächig über der gesamten Hauptoberfläche des Hilfssubstrats 6 angeordnet.

Zunächst soll kurz erläutert werden, wie die in Fig. 1a gezeigte Struktur aus Hilfssubstrat 6 und Schaltungschips 2 erreicht werden kann. Dabei wird zunächst von einem Halbleiterwafer ausgegangen, wobei in einer Hauptoberfläche desselben integrierte Schaltungen gebildet sind. In dieser Hauptoberfläche des Halbleiterwafers wird nachfolgend eine Grabenstruktur erzeugt, die die Umrisse der zu vereinzelnden Schaltungschips festlegt, wobei die Tiefe der Grabenstruktur die Dicke der Schaltungschips definiert. Nachfolgend wird diese Oberfläche des Halbleiterwafers, in der die Grabenstruktur gebildet ist, beispielsweise mittels einer Haftschicht 4 auf ein Hilfssubstrat 6 aufgebracht. Nachfolgend wird der Halbleiterwafer von der Rückseite her bis zu der Unterseite der Grabenstruktur gedünnt, wodurch sich die in Fig. 1a gezeigte Struktur ergibt, bei der die einzelnen Schaltungschips durch die Grabenstruktur 8 vereinzelt sind. Zur Handhabung dieser vereinzelten Schaltungschips gemäß der vorliegenden Erfindung wird nun eine Mehrzahl von Greifköpfen 10 benachbart zu einer Mehrzahl von Schaltungschips 8 positioniert. In Fig. 1a sind zur Veranschaulichung sechs Greifköpfe 10 gezeigt. Diese Greifköpfe können in einer Reihe angeordnet sein oder eine flächige Matrix von beispielsweise 6 x 6 Greifköpfen zum gleichzeitigen Aufnehmen von 36 Schaltungschips bilden. Die Greifköpfe können die Schaltungschips mittels einer beliebigen geeigneten Technik aufnehmen, beispielsweise durch magnetische Anziehung, durch elektrostatische Anziehung oder durch eine Anziehung mittels Unterdruck. Alternativ können die Greifköpfe 10 auf der Oberfläche, die mit den Schaltungschips 8 in Berührung kommt, eine Haftschicht aufweisen.

Um nun die Schaltungschips 8 von dem Hilfssubstrat 6 abzulösen, wird mittels geeigneter Vorrichtungen 12 Energie zu den Verbindungsstellen zwischen den Schaltungschips 8 und dem Hilfssubstrat 6 zugeführt. Bei bevorzugten Ausführungsbeispielen wird zu diesem Zweck ein Laserbeschuß der Verbindungsstellen durchgeführt. Alternativ kann eine Ultraschallbestrahlung oder eine Wärmebehandlung erfolgen, um die Verbindung zwischen den Schaltungschips 8 und dem Hilfssubstrat 6 zu lösen. Daneben kann die Verbindung zwischen den Schaltungschips 8 und dem Hilfssubstrat 6 auch durch eine Ultraviolett-Licht-Bestrahlung gelöst werden. Eine weitere Möglichkeit zum Ablösen des Schaltungschips besteht darin, diese naßchemisch von dem Hilfssubstrat 6 zu lösen, indem über eine Kanüle lokal Lösungsmittel zugeführt wird. Darüberhinaus können die Schaltungschips auch trockenchemisch durch lokales Erzeugen eines Plasmas von dem Hilfssubstrat 6 gelöst werden Dieses Ablösen kann, wie in Fig. 1a gezeigt ist, jeweils lokal durch eine Mehrzahl geeigneter Vorrichtungen 12 erfolgen. Alternativ kann nur eine Vorrichtung vorgesehen sein, durch die gleichzeitig alle Schaltungschips, an denen Greifköpfe 10 angeordnet sind, von dem Hilfssubstrat 6 gelöst werden.

Obwohl die Vorrichtung bzw. die Vorrichtungen 12 in Fig. 1a derart angeordnet ist bzw. sind, daß die Energie von der Rückseite des Hilfssubstrats 6 her zugeführt wird, ist es für Fachleute offensichtlich, daß diese Energie beispielsweise auch von der Seite oder mittels der Greifköpfe 10 selbst zugeführt wird.

Alternativ können die Schaltungschips mittels elektrostatischer oder magnetischer Kupplungen an dem Hilfssubstrat gehalten sein. Ferner ist es möglich, die Schaltungschips mittels Unterdruck an dem Hilfssubstrat zu halten. In diesen Fällen ist es jeweils nur notwendig, den jeweiligen Haltemechanismus abzustellen, um die Schaltungschips von dem Hilfssubstrat abzulösen.

Die Greifköpfe 10 sind mit einer Positionierungseinrichtung eines Chiphandhabungssystems verbunden. Die Positionierungseinrichtung kann einen beliebigen in der Robotertechnik bekannten Aufbau aufweisen, solange dieselbe in der Lage ist, die Mehrzahl von Greifköpfen 10 zu steuern, um ein Umsetzen der Schaltungschips 8 unter einer gleichzeitigen Auffächerung der Beabstandung zwischen denselben durchzuführen. Dies geschieht, indem die Positionierungsvorrichtung die Greifköpfe 10 derart bewegt, wie es durch den Pfeil 14 zwischen Fig. 1a und 1b gezeigt ist.

Die von dem Hilfssubstrat 6 abgelösten Schaltungschips 8 sind an den Greifköpfen 10 gehalten und werden zusammen mit den Greifköpfen 10 durch die Positionierungseinrichtung bewegt. In Fig. 1b ist dargestellt, wie die Schaltungschips 8 nachfolgend durch die Positionierungseinrichtung mit einem vergrößerten Abstand zwischen denselben auf den Schaltungssubstraten, auf die dieselben für den bestimmungsgemäßen Gebrauch gebondet werden sollen, plaziert werden. Diese Schaltungssubstrate sind in Fig. 1b als Substratverbund 20 dargestellt, wobei in Fig. 1b ferner Trennlinien 22 gezeigt sind, an denen diese Substrate später vereinzelt werden. Gleichzeitig mit dem Aufsetzen der Schaltungschips 8 mittels der Greifköpfe 10 auf den Substraten des Substratverbunds 20 kann ein Bonden der Schaltungschips 8 mit auf den Schaltungssubstraten angeordneten Bondpads erfolgen, beispielsweise durch die Herstellung einer Flip-Chip-Verbindung. Hierzu sind Einrichtungen 24 vorgesehen, um ein solches Bonden unter Zuführung von Energie zu ermöglichen. Die Einrichtungen 24 können auch in die Greifköpfe 10 integriert sein. Andernfalls können Haftflächen auf den Schaltungssubstraten vorgesehen sein, auf die die Schaltungschips 8 geklebt werden.

Die vorliegende Erfindung schafft somit ein Verfahren zur Handhabung einer Mehrzahl von Schaltungschips, das eine schnelle und kosteneffiziente Fertigung von beispielsweise elektronischen Etiketten ermöglicht. Somit ermöglicht die vorliegende Erfindung Massenfertigungsverfahren für derartige elektronische Etiketten, indem gleichzeitig eine Mehrzahl von Schaltungschips von einem Hilfsträger abgelöst wird, die Beabstandung zwischen den Schaltungschips geeignet aufgefächert wird, und die Schaltungschips beispielsweise in der Ausnehmung eines isolierenden Substrats, auf dem eine Antenneneinrichtung vorgesehen ist, plaziert werden.

## Patentansprüche

1. Verfahren zur parallelen Handhabung einer Mehrzahl von Schaltungschips (8), die in einer ersten Anordnung, die der Anordnung derselben im ursprünglichen waferverbund entspricht, auf der Oberfläche eines Hilfsträgers (6) angeordnet sind, mit den folgenden Schritten:
gleichzeitiges Aufnehmen der Mehrzahl von Schaltungschips (8) durch eine Mehrzahl von Aufnahmeeinrichtungen (10) ;
gleichzeitiges Bewegen der Mehrzahl von Aufnahmeeinrichtungen (10) mit den aufgenommenen Schaltungschips (8) zu einem oder mehreren Trägern (20), derart, daß gleichzeitig mit der Bewegung die erste Anordnung der Schaltungschips (8) in eine zweite, von der ersten Anordnung verschiedene Anordnung geändert wird; und
gleichzeitiges Plazieren der Schaltungschips (8) in der zweiten Anordnung auf dem oder den Trägern (20).

2. Verfahren gemäß Anspruch 1, bei dem die jeweiligen Schaltungschips (8) erste Beabstandungen zwischen denselben aufweisen, wenn sie in der ersten Anordnung. sind, und bei dem die jeweiligen Schaltungschips (8) zweite Beabstandungen zwischen denselben aufweisen, wenn sie in der zweiten Anordnung sind.

3. Verfahren gemäß Anspruch 2, bei dem die ersten Beabstandungen kleiner sind als die zweiten Beabstandungen.

4. Verfahren nach einem der Ansprüche 1 bis 3, bei dem die Aufnahme eines jeweiligen Schaltungschips (8) durch eine jeweilige Aufnahmeeinrichtung (10) durch eine magnetische Kupplung, eine elektrostatische Kupplung, eine Unterdruckkupplung oder durch eine Haftschicht auf einer jeweiligen Aufnahmeeinrichtung (10) bewirkt wird.

5. Verfahren nach einem der Ansprüche 1 bis 4, bei dem die jeweiligen Schaltungschips (8) durch Zufuhr von Energie zu der Verbindungsstelle zwischen Hilfsträger (6) und Schaltungschip (8) von dem Hilfsträger (6) gelöst werden, wenn dieselben von den jeweiligen Aufnahmeeinrichtungen (10) aufgenommen werden.

## Claims

1. A method for the handling in parallel a plurality of circuit chips (8), which are arranged in a first arrangement, which corresponds to their arrangement in the original wafer, on the surface of an auxiliary carrier (6), comprising the following steps:
simultaneously picking up the plurality of circuit chips (8) by a plurality of pick up devices (10);
simultaneously moving the plurality of pick up devices (10) with the picked up circuit chips (8) to one or several supports (20) in such a way that simultaneously with the motion the first arrangement of the circuit chips (8) is changed into a second arrangement, which is different from the first arrangement; and
simultaneously placing the circuit chips (8) in the second arrangement onto said one or several carriers (20).

2. A method of claim 1, wherein the respective circuit chips (8) have first distances therebetween when being in the first arrangement, and wherein the respective circuit chips (8) have second distances therebetween when being in the second arrangement.

3. A method of claim 2, wherein the first distances are smaller than the second distances.

4. The method of claim 1 to 3, wherein the picking up of a respective circuit chip (8) is effected by a respective pick up device (10) by a magnetic coupling, an electrostatic coupling, a vacuum coupling or an adhesive layer on a respective pick up device (10).

5. A method of claim 1 to 4, wherein the respective circuit chips (8) are separated from the auxiliary support (6) by adding energy to the place of connection between the auxiliary support (6) and the circuit chip (8), when the same are picked up by the respective pick up devices (10).

## Revendications

1. Procédé pour la manipulation en parallèle d'une pluralité de puces de connexion (8) qui sont disposées selon une première disposition, correspondant à la disposition de ces dernières dans la liaison en plaquette originale, sur la surface d'un support auxiliaire (6), aux étapes suivantes consistant à :
prélever simultanément la pluralité de puces de connexion (8) par une pluralité de dispositifs de prélèvement (10) ;
déplacer simultanément la pluralité de dispositifs de prélèvement (10) avec les puces de connexion (8) prélevées vers un ou plusieurs supports (20), de sorte que la première disposition des puces de connexion (8) est, simultanément avec le déplacement, changée en une seconde disposition différente de la première disposition ; et
placer simultanément les puces de connexion (8) selon la seconde disposition sur le ou les supports (20).

2. Procédé selon la revendication 1, dans lequel les puces de connexion (8) respectives présentent entre elles des premiers écartements lorsqu'elles se trouvent selon la première disposition et dans lequel les puces de connexion (8) respectives présentent entre elles des seconds écartements lorsqu'elles se trouvent selon la seconde disposition.

3. Procédé selon la revendication 2, dans lequel les premiers écartements sont inférieurs aux seconds écartements.

4. Procédé selon l'une des revendications 1 à 3, dans lequel le prélèvement de l'une des puces de connexion (8) respectives est réalisé par un dispositif de prélèvement (10) correspondant par couplage magnétique, couplage électrostatique, couplage par dépression ou par une couche d'adhérence sur un dispositif de prélèvement (10) correspondant.

5. Procédé selon l'une des revendications 1 à 4, dans lequel les puces de connexion (8) respectives sont séparées du support auxiliaire (6) par amenée d'énergie au point d'assemblage entre support auxiliaire (6) et puce de connexion (8), lorsqu'elles sont prélevées par les dispositifs de prélèvement (10) correspondants.
